(19) Europäisches Patentamt
European Patent Office
Office européen des brevets

(11) **EP 4 553 528 A1**

(12) **EUROPEAN PATENT APPLICATION**

(43) Date of publication:
**14.05.2025 Bulletin 2025/20**

(21) Application number: **23209384.9**

(22) Date of filing: **13.11.2023**

(51) International Patent Classification (IPC):
***G01R 33/385*** (2006.01)   ***G01R 33/54*** (2006.01)
***G01R 33/48*** (2006.01)

(52) Cooperative Patent Classification (CPC):
**G01R 33/3854; G01R 33/546;** G01R 33/4808

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Koninklijke Philips N.V.**
**5656 AG Eindhoven (NL)**

(72) Inventors:
- **AMTHOR, Thomas Erik**
  **Eindhoven (NL)**
- **FINDEKLEE, Christian**
  **Eindhoven (NL)**

(74) Representative: **Philips Intellectual Property & Standards**
**High Tech Campus 52**
**5656 AG Eindhoven (NL)**

(54) **COMMUNICATION SYSTEM WITH SYNTHETIC GRADIENT COIL NOISE**

(57) Disclosed herein is a communication system (100, 400) comprising a local communication node (102). The local communication node comprises a local memory (110) storing local machine executable instructions (120) and a synthetic gradient noise generation module (122). The synthetic gradient noise generation module is configured to output synthetic gradient coil noise (126) in response to receiving gradient coil sensor data as input. The local communication node further comprises a local computational system (104). Execution of the local machine executable instructions causes the local computational system to: receive (200) the gradient coil sensor data (124) from a gradient coil sensor (314, 422); receive (202) the synthetic gradient coil noise in response to inputting the gradient coil sensor data into the synthetic gradient noise generation module; and provide (204) the synthetic gradient coil noise.

Fig. 1

## Description

FIELD OF THE INVENTION

The invention relates to remote medical communication, in particular to communication related to magnetic resonance imaging.

BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. Various quantities or properties of the subject can be measured spatially and imaged using MRI. During an MRI procedure, time dependent gradient magnetic fields are imposed within an imaging zone using magnetic field gradient coils (commonly referred to as gradient coils). Due to the large B0 field, when the electrical current supplied to the gradient coils changes large amounts of acoustic noise can be generated. This acoustic noise is often repetitious and typically sounds like a knocking or clicking sound. The acoustic noise generated by the gradient coils is referred to as gradient coil noise.

United State patent application US 2020/0041589 A1 discloses magnetic resonance device comprising a gradient coil assembly having gradient coils is described. The gradient coils are supported by at least one cylindrical coil carrier for generating gradient fields. As part of the gradient coil assembly, at least one vibration sensor is provided for measuring vibrations of the gradient coil assembly at least in a radial direction of oscillation.

SUMMARY OF THE INVENTION

The invention provides for a communication system, an indication method, and a computer program in the independent claims. Embodiments are given in the dependent claims.

In one aspect the invention provides for a communication system that comprises a local communication node. The local communication node comprises a local memory storing machine-executable instructions and a synthetic gradient noise generation module. The synthetic gradient noise generation module is configured to output synthetic gradient coil noise in response to receiving gradient coil sensor data as input. The local communication node further comprises a local computational system.

Execution of the local machine-executable instructions causes the local computational system to receive the gradient coil sensor data from a gradient coil sensor. Execution of the local machine-executable instructions further causes the local computational system to receive the synthetic gradient coil noise in response to inputting the gradient coil sensor data into the synthetic gradient noise generation module. Execution of the machine-executable instructions further causes the local computational system to provide the synthetic gradient coil noise.

In another aspect, the invention provides for a communication method. The method comprises receiving gradient coil sensor data from a gradient coil sensor. The method further comprises receiving synthetic gradient coil noise in response to inputting the gradient coil sensor data into a synthetic gradient noise generation module. The synthetic gradient noise generation module is configured to output synthetic gradient coil noise in response to receiving the gradient coil sensor data as input. The method further comprises providing the synthetic gradient coil noise.

In another aspect, the invention provides for a computer program comprising local machine-executable instructions and a synthetic gradient noise generation module. The synthetic gradient noise generation module is configured to output synthetic gradient coil noise in response to receiving gradient coil sensor data as input. Execution of the machine-executable instructions causes a local computational system to receive the gradient coil sensor data from a gradient coil sensor. Execution of the machine-executable instructions further causes the local computational system to receive the synthetic gradient coil noise in response to inputting the gradient coil sensor data into the synthetic gradient noise generation module. Execution of the machine-executable instructions further causes the local computational system to provide the synthetic gradient coil noise.

BRIEF DESCRIPTION OF THE DRAWINGS

In the following preferred embodiments of the invention will be described, by way of example only, and with reference to the drawings in which:

Fig. 1 illustrates an example of a communication system.
Fig. 2 shows a flow chart which illustrates a method of using the communication system of Fig. 1.
Fig. 3 illustrates a further example of a communication system that illustrates the functionality of both a local communication node and a remote communication node.
Fig. 4 illustrates a further example of a communication system integrated with a magnetic resonance imaging system.

DETAILED DESCRIPTION OF EMBODIMENTS

Like-numbered elements in these figures are either equivalent elements or perform the same function. Elements which have been discussed previously will not necessarily be discussed in later figures if the function is equivalent.

Examples may provide for a communication system comprising a local communication node. The communication system may also comprise a remote communication node which is able to exchange information, data, and/or control signals with the local communication node. The local communication node comprises a local memory that stores machine-executable instructions and a synthetic gradient noise generation module. The synthetic gradient noise generation module is configured to output synthetic gradient coil noise in response to receiving gradient magnetic sensor data as input. It is understood that the synthetic gradient coil noise is a signal which may be rendered by an audio system. The gradient coils in a magnetic resonance imaging system are used to generate gradient magnetic fields during the course of a magnetic resonance imaging protocol. As magnetic resonance imaging is carried out in a large static magnetic field, putting current into the gradient coils may result in large acoustic noises. The acoustic noise is referred to as gradient coil noise as used herein. The gradient coil noise may interfere with normal communications between the operator and the subject being examined by a magnetic resonance imaging system. Because the subject is within the magnetic resonance imaging system the acoustic noise generated by the gradient coils may interfere with speech or audio which is rendered to the subject. Likewise, if a microphone is placed in the vicinity of a subject the microphone will not only pick up speech from the subject but also gradient coil noise.

The gradient coil noise may also provide another benefit to the operator of a magnetic resonance imaging system in determining if the system is functioning properly. Typically, operators are able to recognize the acoustic signature or sound of different magnetic resonance imaging protocols. By merely listening to the gradient coil noise an operator may be able to tell such things as what magnetic resonance imaging protocol is being performed as well as being able to understand if the magnetic resonance imaging system is functioning properly. Some or all of the current embodiments may allow a remote support operator to detect possible problems with a local MRI machine. This could be utilized within the context of a remote operations command center, such as the ROCC system of Philips.

The local communication node further comprises a local computational system. The local computational system may refer to one or more computational systems located in one or more locations. Execution of the local machine-executable instructions causes the local computational system to receive the gradient coil sensor data from a gradient coil sensor. Execution of the local machine-executable instructions causes the local computational system to receive the synthetic gradient coil noise in response to inputting the gradient coil sensor data into the synthetic gradient noise generation module. Execution of the local machine-executable instructions further causes the local computational system to provide the synthetic gradient coil noise.

Examples may provide for multiple benefits, both technical and clinical. The gradient coil sensor may be a sensor that detects the operation of the gradient coil by measuring a magnetic sensor or signal. For example, the gradient coils for a magnetic resonance imaging system are supplied with a current to generate the magnetic gradient fields. Current sensors may be one type of gradient coil sensor as they sense the magnetic field generated by changes in the current. Another possibility is to use a magnetic field sensor to measure changes in the magnetic field due to use of the gradient coils. The gradient coil sensors in this case only measure the activity of the gradient coils of the magnetic resonance imaging system. They therefore filter out and are not affected by other acoustic noise such as speech or other noise occurring within the examination or being generated by the operator.

During operation of a magnetic resonance imaging system the gradient magnetic fields produced by the gradient coils may be in the range of 1-100mT (strongly depending on the exact location where the measurement is made). If a magnetic field sensor is used, then it may be able to measure changes in the overall magnetic field using the same range. The current in the gradient coil reaches around up to 100A, voltages might also be a few 100V at the gradient coil. The voltage drop along the cable may be approximately a few volts due to the small resistance. If the gradient coil sensor data comprises current measurements, then it would typically measure between 0 and 100A (or several hundred amps). If the gradient coil sensor data comprises voltage drop measurements across one or more gradient coils, then it would likely measure between 0 and 100V (or several hundred volts).

The synthetic gradient noise generation module therefore may provide for a system for generating a pure gradient coil noise signal that is unaffected by other sources. The synthetic gradient coil noise may be used for a variety of purposes within a communication system. A communication system as used herein may encompass one or more communication nodes, such as a one or more local communication nodes that may potentially communicate with or exchange data with one or more remote communication nodes. In one example the synthetic gradient coil noise could be provided to a remote communication node so that a remote operator is able to experience the gradient coil noise without any other interferences. This may for example enable an operator to use this gradient coil noise without being distracted by speech. Another benefit is the synthetic gradient coil noise could potentially be used for noise cancellation. This may be used for cancelling noise signal heard by a subject who is undergoing a magnetic resonance imaging examination as well as the local operator of a magnetic resonance imaging system. For example, the synthetic gradient coil noise could be used to help cancel or remove gradient coil noise from a microphone used to capture speech from the subject during a magnetic resonance imaging examination.

Experienced technologists are used to listening to the sound of an MRI system and identifying the system status and exam progress by the unique sound of the different sequences.

In a remote setting, this audible feedback is usually lost. Although there may be an audio connection to talk to the local operator(s), this audio connection usually does not transmit the MRI noise, so that the remote expert needs to infer the scanner operation from communication with the local operators or from the messages displayed on multiple shared console screens.

Examples may provide a means to provide audible feedback of (synthesized) MRI sound of multiple imaging systems for a remote expert and a selection logic to allow the remote expert to listen in to one MRI system while working on a task on another machine.

Examples may further make sure not to transmit any spoken words from inside the exam room in order to preserve the patients' privacy.

When multiple MRI procedures need to be supported by a remote expert user, it is crucial for the remote expert to know about the status and progress of the individual imaging examinations.

In some examples, providing the synthetic gradient coil noise comprises transmitting the synthetic gradient coil noise to a remote control center or to a remote communication node. The transmission can be realized in multiple ways, assuming that sufficient bandwidth for in the audio range is provided, including wired USB or other serial connection, wired Ethernet connection, Bluetooth connection, Wi-Fi connection, Zigbee connection (2.4GHz band only because of data rates), and Analog connection (sampling via a sound card of the local processing unit)

In another example, the gradient coil sensor data comprises current sensor data. This could be measured by a pick-up coil which measures the induced voltage which is proportional to the time derivative of the change in the magnetic field due to changes in current supplied to the gradient coils. This pickup coil could be attached (e.g., glued) to the outside of cabling supplying current to the gradient coils without changing or interfering with the system in any way. It could be a pick-up coil or clamp (measuring the derivative of the current flowing in the cable) or a Hall sensor (measuring a voltage directly proportional to the current flowing in the cable). It is to be understood, that these are representative non-limiting examples and other examples may be possible within the context of the present invention.

In another example, the gradient coil sensor data comprises voltage sensor data from one or more gradient coils using a voltage sensor or probe. This could measure a voltage drop at the gradient coil cable or just a small resistor (or some piece of that cable) ($U=R*I$). It could also measure a voltage measurement for the (large) voltage drop at the gradient coil ($U=L*dI/dt$).

In another example, the gradient coil sensor data comprises magnetic field sensor data. The magnetic field sensor data could measurements either of the magnetic field as a function of time or how the magnetic field is changing as a function of time. The changes in the magnetic field, as measured by the magnetic field sensor may be considered to be proportional to the current or change in current provided to the gradient coils. As the mechanical forces in the gradient coil are about proportional to I (current) or I^2 (or more general a power series of I). These forces define the noise generated in the MR system, thus, with the time dependency of either I(t) or the magnetic field, one is able to estimate or model the acoustic noise generated by the gradient coils.

In another example, the gradient coil sensor data comprises current sensor data from one or more gradient coils. This gradient coil current sensor data could for example be from an external current sensor which is attached or incorporated into the gradient coil system of the magnetic resonance imaging system, or it could be a current sensor which is built into the power supply supplying current to the gradient coils. In some instances, the gradient coils may also provide a functionality where a current sensor is built into them. The gradient coil may therefore comprise the current sensor. This embodiment may be beneficial because it provides a very accurate measure of the current flowing through individual gradient coils. This may provide for more accurate or better modeling of the synthetic gradient coil noise. The operator listening to the synthetic gradient coil noise may better understand the functioning of a magnetic resonance imaging system because the synthetic gradient coil noise firstly does not contain any other distracting background noises. Another advantage is that the synthetic gradient coil noise may be presented or rendered in a uniform manner where, for example the volume is sent to a consistent level during different examinations.

Improved noise modeling of the gradient coil nose may make the sound feel more "natural" and more similar to what the remote expert technologist may be used to hearing. It may improve the remote expert's ability to understand what is happening at the MR scanner (even subconsciously).

In another embodiment the gradient coil sensor data comprises gradient coil magnetic field sensor data. In this example, fluctuations in the magnetic field are measured using a magnetic field sensor. As the primary time dependent perturbations to the magnetic field within the imaging zone are caused by the magnetic field gradient coils, this may also provide a convenient and accurate means of measuring the actual activity of the gradient coils of a magnetic resonance imaging system. This may also provide for accurate modeling of the synthetic gradient coil noise.

In another example the synthetic gradient noise generation module is implemented as a transfer function. This may be beneficial because it may provide an accurate and reproducible model of the synthetic gradient coil noise. A brief explanation of how to implement a transfer function is provided below.

The local computational system transforms the measured signal(s) to a synthetic audio signal, resembling the audible sound of the MRI.

Assuming that the gradient coil behaves like a linear time-invariant system, the electric signal $x(t)$ (the current, voltage, or time dependent change of the magnetic field) picked up from the gradient cable can be transformed into expected sound waves $y(t)$ using a linear transfer function H:

$$Y(f) = H(f)X(f)$$

where $X$ and $Y$ represent the Fourier transforms of $x$ and $y$, respectively.

The transfer function can be determined experimentally by measuring the real sound produced by a given gradient signal with a microphone in the exam room or can be derived by magneto-mechanical simulation of the magnet and gradient system. The transfer function may be vendor- and system-specific and can be implemented specifically for a given system type. A more advanced embodiment may of cause also include a non-linear model.

If an explicit transfer function is not available, synthetic sound that at least resembles the real sound can already be created by using an identity function $H = 1$, i.e., interpreting the measured gradient current as sound waves, or it can be estimated empirically.

In some examples, the transfer function (or maybe in addition with a power series before the transfer function) is used to generate a more realistic acoustic noise signal from the sensor data.

In another example the synthetic gradient noise generation module is implemented as a neural network. The use of a neural network may also provide for accurate means of modeling the synthetic gradient coil noise. Training data can be used to train the neural network. For example, a magnetic resonance imaging system can be used to simultaneously collect gradient coil sensor data and record the resulting acoustic noise in the magnetic resonance imaging system. Pairing this data may provide for training data which can be used for example for a deep learning procedure in training the neural network.

In another example, the neural network is a recurrent neural network (RNN).

In another embodiment the neural network is a long short-term memory network (LSTM).

A typical RNN or LSTM used to implement an example could function like this:

The input to the RNN or LSTM is the time series signal (the gradient coil sensor data) measured by the sensor. The RNN/LSTM continuously predicts output values based on the input time series it has seen so far. In this case, it could be trained to predict the audio signal from the sensor signal, one step at a time. It can be trained in a supervised way by supplying sensor signal and recorded audio (ground truth). The RNN/LSTM is typically built up as a standard "cell" containing a state memory that is updated based on the input time series.

In another embodiment the neural network is a convolutional neural network. For example, collections or groups of the gradient coil magnetic field sensor data can be input into the convolutional neural network and then output as groups.

In another embodiment the communication system further comprises a magnetic resonance imaging system.

In another example, the communication system further comprises a combined magnetic resonance imaging system and a positron emission tomography system.

In another example, the communication system further comprises a combined magnetic resonance imaging system and a linear accelerator, LINAC, system.

In another example, the magnetic resonance imaging system further comprises a magnetic gradient coil system. The communication system further comprises the gradient coil sensor configured for measuring the gradient coil sensor data from the magnetic gradient coil system. As is mentioned above, this may for example be achieved by either integrating current sensors into the magnetic gradient coil system or using external magnetic field sensors which are able to measure the magnetic fields generated by the magnetic gradient coil system.

In another example, the gradient coil sensor is a current sensor configured for measuring current provided by the gradient coil system. This example may be particularly beneficial because it not only provides accurate measurements of the use of the gradient coil system but may also be useful in detecting faults or errors in the component chain of the gradient coil system.

In another example, the gradient coil sensor is a magnetic field sensor configured for measuring a gradient magnetic field produced by the magnetic gradient coil system. The measurement of the gradient magnetic field may also provide an accurate measure of the use of the gradient coil system as well as be useful in detecting faulty behavior.

In another example, the communication system further comprises a network interface configured for establishing a remote access channel between the local communication node and a remote communication node. Execution of the machine-executable instructions further causes the local computational system to transmit the synthetic gradient coil noise to the remote communication node via the remote access channel. This example may be beneficial because it may enable the remote communication node to use the synthetic gradient coil noise. The providing of the synthetic gradient coil noise may for example be used for removing the gradient coil noise from voice signals from the operator and/or the subject being examined as well as to provide noise which provides feedback to a remote operator to experience the gradient coil noise so as to detect faults in the system or to understand the current magnetic resonance imaging protocol being performed.

In another example, the local communication node further comprises a local user interface. The local user interface may for example be a display or user interface which is used by a local operator to control the local communication system. In some examples, when there is a magnetic resonance imaging system, the local user interface may be used for control and operation of the magnetic resonance imaging system. The local communication node further comprises a local screen replicator configured for generating images of the local user interface. The local screen replicator may take different forms in different examples. They may for example be a screen scraper, be implemented as a software API or similar technology. A particular problem in controlling medical imaging systems remotely is that the software used for controlling the system may not be available or it may not be desirable to modify this software. The local screen replicator may for example be a hardware device that sits between a signal sent to the local user interface and the local computer or computational system. The images of the local user interface can then be generated using hardware and it is not necessary to modify the software of a potentially old magnetic resonance imaging system or system from a different manufacturer.

The local communication node further comprises a local remote human interface device that is configured for receiving control data from the remote communication node via the remote access channel. Again, this local remote human interface device could be implemented via software such as an API or a screen scraping algorithm. In other cases, the local remote human interface device may again be a hardware device. For example, a USB device may be plugged into a computer which then interfaces with a network device. The local remote human interface device is then able to emulate human interface devices such as a keyboard or mouse. This may then enable an operator potentially in the remote communication node to operate the local communication node as if the operator were there. In this case it may then be achieved without any software modification to the local communication node. This again may enable incorporating medical imaging systems in general, or magnetic resonance imaging systems specifically, into the communication system even when the software for the medical imaging device or magnetic resonance imaging system is not available.

Execution of the local machine-executable instructions further causes the local computational system to transmit the images of the local user interface to a remote communication node via the remote access channel. Execution of the local machine-executable instructions further causes the local computational system to receive the control data from the remote communication node via the remote access channel. Execution of the local machine-executable instructions further causes the local computational system to control the user interface using the control data. This embodiment may be beneficial because it may provide for the local control and operation of a medical imaging system such as a magnetic resonance imaging system from the remote communication node.

In another example, the communication system further comprises the remote communication node. The remote communication node comprises a remote user interface configured for displaying the images of the user interface received via the remote access channel. The remote communication node further comprises a remote user interface device configured for receiving the control data and then transmitting the control data via the remote access channel. This could for example be a conventional mouse or keyboard and then the remote communication node then transmits this data via the remote access channel to the local communication node. The remote communication node further comprises a remote audio system configured for rendering the synthetic gradient coil noise received via the remote access channel. The rendering of the synthetic gradient coil noise may provide an additional aspect to the user interface that is provided remotely via the remote communication node. For example, rendering the synthetic gradient coil noise may provide for a better simulation which enables a remote operator to better operate the magnetic resonance imaging system that is part of the local communication node or associated with the local communication node.

In another aspect, the remote communication node is configured for receiving the remote access channel from multiple local communication nodes simultaneously. The remote communication node is further configured to render the synthetic gradient coil noise received via the remote access channel from the local communication node while transmitting control data to a second local communication node. This may have the benefit that it enables the operator of the remote communication node to monitor two local communication nodes simultaneously. There is the local communication node which is associated with the operation of a user interface and the second local communication node provides this audio feedback via its synthetic gradient coil noise. Experienced operators can listen to gradient coil noise and subconsciously be aware of the type of magnetic resonance imaging protocol, the status or point within the examination and also if there is a problem or fault in the magnetic resonance imaging protocol. This may therefore provide for a subconscious monitoring of the second local communication node. The remote technologist may be enabled to be aware of what is happening at one site (by subconsciously processing the audio signal), while working with another site.

In another aspect the remote communication node further comprises a decision module configured for choosing the local communication node from the multiple local communication nodes. For example, there may be a predetermined criteria which is used to select the local communication node. The decision module may also monitor it and determine which magnetic resonance imaging systems at which local communication nodes are currently active. It could then route a synthetic gradient coil noise from a magnetic resonance imaging system that is currently in operation.

The decision module could be configured in different ways. The remote operator using the remote communication node may choose to connect with any distinct system what would mean, he or she switches e.g., to a full-screen mode of that systems console screen and at the same time connects to the synthetic gradient coil noise.

There may be a predetermined criteria which is used to select the local communication node from multiple local communication nodes. The decision module may also monitor it and determine which magnetic resonance imaging systems at which local communication nodes are currently active. It could then route a synthetic gradient coil noise from a magnetic resonance imaging system that is currently in operation.

The decision module could control which local communication node provides the synthetic gradient depending on the received audio streams which contain the synthetic gradient coil nose from the different local communication nodes. One implementation of the decision module could be to always switch the remote audio output to the system where synthetic gradient coil noise has just started. This may be advantageous because if a magnetic resonance imaging system is malfunctioning it may be apparent because the synthetic gradient coil has odd or missing noise components. Automatically switching to the most recently started synthetic gradient coil noise may provide a means for the remote operator to detect faults in magnetic resonance imaging system without having to consciously monitor them.

The remote expert operating the remote communication node may in general support multiple local sites simultaneously. In order to observe the scanning progress at one site via audible MR sound feedback while communicating with or otherwise supporting a second site, the remote expert may to select the local site from which to share the MR audio feedback independently of the site currently being supported via screen sharing or video communication.

This can be realized in different ways using a decision module, as exemplary provided in the following paragraphs.

In a remote user interface, there can be an audio feedback switch for each connected site, so that the operator can switch on MR audio feedback for each site separately while interacting with any other site. When switching to another site, it might be preferred to automatically mute all the others.

When multiple screens are used to provide console screen sharing of multiple sites, audio feedback control switches can also be displayed as an overlay UI element on each shared console screen. Alternatively, an eye tracking camera can be used to determine which shared screen the operator is currently looking at to automatically switch to the respective MR audio feedback stream of the respective site.

In another example, the local communication node further comprises a noise cancellation system. This noise cancellation system may for example be either for the subject being examined during a magnetic resonance imaging examination or an operator operating the local communication node or the remote communication node. For example, the noise cancellation system may be used to remove gradient coil noise from a microphone listening to speech by the subject. Execution of the local machine-executable instructions further causes the local computational system to control the noise cancellation system using the synthetic gradient coil noise.

The noise cancellation system could be an "anti-sound" technology, i.e., would emit the sound with a 180-degree phase shift at the subject's ear, so that sound waves cancel. It could also remove the noise from any audio stream by overlaying a phase-shifted audio signal or by filtering (subtracting) in the Fourier space.

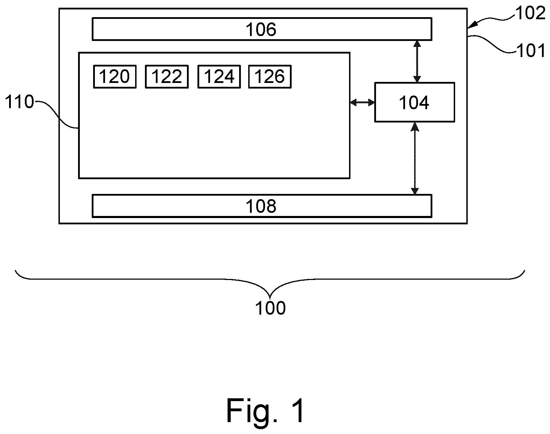

Fig. 1 illustrates a local communication node 102 of a communication system 100. The local communication node 102 in this example may be a computer 101. The local communication node 102 comprises a local computational system 104 that may represent one or more computing cores at one or more locations. The local computational system 104 is in communication with a network and/or hardware interface 106. The network interface 106 may allow the local computational system 104 to send and receive messages to a remote communication node. The interface 106 may also enable the local computational system 104 to control other components such as a magnetic resonance imaging system if they are present.

The local computational system 104 is in further communication with a local user interface 108. The local user interface 108 may for example contain displays and human interface devices which enable an operator to operate and control the local communication node 102. The communication system 100 is further shown as containing a local memory 110. The local memory 110 is intended to represent various types of volatile or nonvolatile memory that are accessible to the local computational system 104. In some examples the local memory 110 is a computer-readable non-transitory storage medium.

The local memory 110 is shown as containing local machine-executable instructions 120. The local machine-executable instructions 120 may enable the local computational system 104 to perform such tasks as controlling other components and providing basic networking and data processing capabilities. The local memory 110 is further shown as containing a synthetic gradient noise generation module 122. The synthetic gradient noise generation module 122 may for example be a neural network or an algorithmic module. The memory 110 is further shown as containing gradient coil sensor data 124. The local memory 110 is further shown as containing synthetic gradient coil noise 126 that has been received in response to inputting the gradient coil sensor data 124 into the synthetic gradient noise generation module 122.

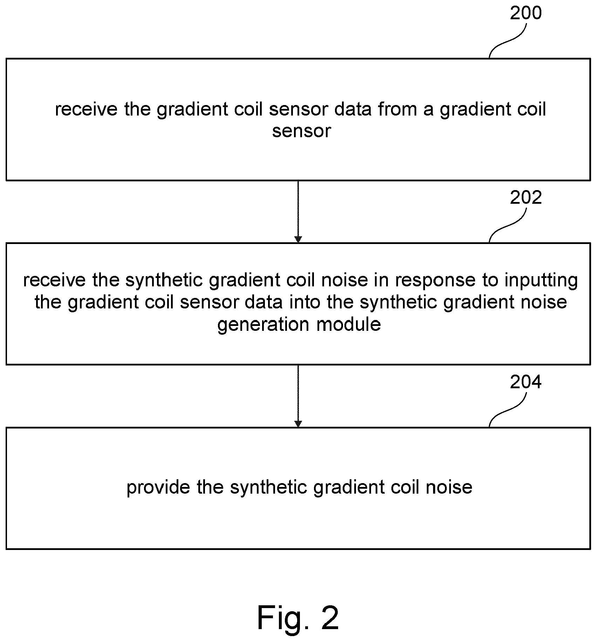

Fig. 2 shows a flowchart which illustrates a method of operating the communication system 100 of Fig. 1. In step 200 the gradient coil sensor data 124 is received from a gradient coil sensor. In step 202 the synthetic gradient coil noise 126 is received in response to inputting the gradient coil sensor data 124 into the synthetic gradient noise generation module 122. In step 204, the synthetic gradient coil noise 126 is provided. This may include providing it for a noise cancellation system or providing it to a remote communication node via the network interface 106. The steps 200, 202, and 204 may be repeated multiple times.

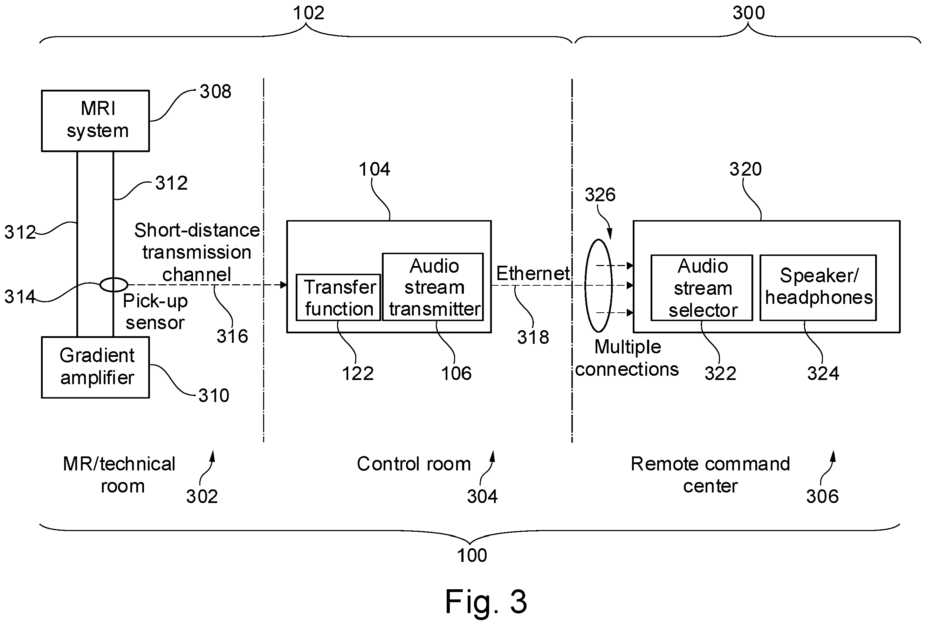

Fig. 3 shows a further view of the communication system 100. It is shown as comprising a local communication node 102 and a remote communication node 300. The local communication node 102 is shown as optionally comprising components from the magnetic resonance and technical room 302 and components from the control room 304. The remote communication node 300 is shown as optionally comprising components from a remote command center 306.

Within the magnetic resonance and technical room 302 there is a magnetic resonance imaging system 308 which has its gradient coils connected to a gradient amplifier 310 via power lines 312. There is a pickup sensor 314 which is used to measure either a voltage or current signal and this is transmitted via a short distance transmission channel 316 to the local computational system 104. Within the local computational system 104 is programmed to use the synthetic gradient noise generation module 122 to take the received gradient coil sensor data 124 and produce the synthetic gradient coil noise 126. This is transmitted via an audio stream transmitter, which in this case may be a network or hardware interface 106 via the ethernet to the remote computational system 320. The ethernet connection may form a remote access channel 318. For example, user interface images or data may be transmitted via the remote access channel 318 from the local computational system 104 to the remote computational system 320. Likewise, user interface control data may be transmitted from the remote computational system 320 to the local computational system 104 to control the local user interface of the local communication node 102, for example to control the operation and function of the magnetic resonance imaging system 308.

Within the remote communication node 300 the remote computational system 320 is shown as having a decision module 322 which is able to select from multiple connections 326 which is the remote access channel 318 which provides the audio stream. Once the remote access channel 318 is selected, the audio signal may be rendered using a remote audio system 324. It may for example be rendered using speakers and/or headphones.

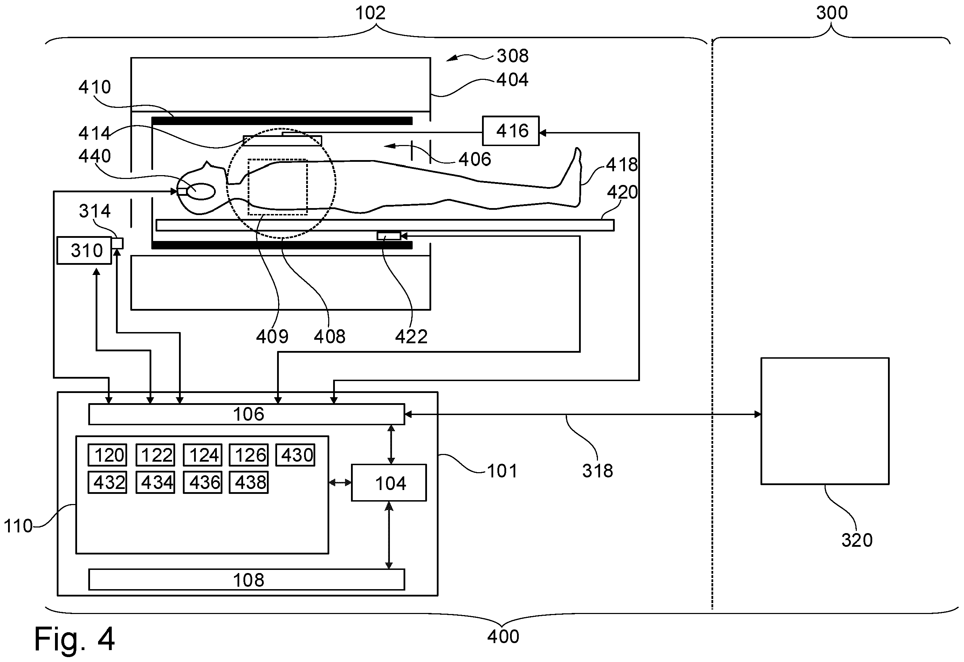

Fig. 4 shows a further view of a communication system 400. The communication system 400 depicted in Fig. 4 is similar to the communication system 100 depicted in Fig. 3 except that more details of the magnetic resonance imaging system 308 are detailed.

The magnetic resonance imaging system 308 comprises a magnet 404. The magnet 404 is a superconducting cylindrical type magnet with a bore 406 through it. The use of different types of magnets is also possible; for instance, it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 406 of the cylindrical magnet 404 there is an imaging zone 408 where the magnetic field is strong and uniform enough to perform magnetic resonance imaging. A field of view 409 is shown within the imaging zone 408. The k-space data that is acquired typically acquired for the field of view 409. The region of interest could be identical with the field of view 409 or it could be a sub volume of the field of view 409. A subject 418 is shown as being supported by a subject support 420 such that at least a portion of the subject 418 is within the imaging zone 308 and the field of view 409.

Within the bore 406 of the magnet there is also a set of magnetic field gradient coils 410 which is used for acquisition of preliminary k-space data to spatially encode magnetic spins within the imaging zone 408 of the magnet 404. The magnetic field gradient coils 410 connected to a magnetic field gradient coil power supply 310. The magnetic field gradient coils 410 are intended to be representative. Typically, magnetic field gradient coils 410 contain three separate sets of coils for spatially encoding in three orthogonal spatial directions. A magnetic field gradient power supply supplies current to the magnetic field gradient coils. The current supplied to the magnetic field gradient coils 410 is controlled as a function of time and may be ramped or pulsed. The pickup sensor 314 is shown as being between the gradient amplifier 310 and the magnetic field gradient coils 410. The pickup sensor 314 may measure the current and/or the voltage being delivered to the magnetic field gradient coils 410. This may be one source to provide data for the gradient coil sensor data 124.

Within the bore 406 of the magnet 404 is also shown as magnetic field sensor 422. The magnetic field sensor 422 is configured for measuring changes in the magnetic field and to detect changes in the gradient field due to the magnetic field gradient coils 410. The magnetic field data measured by the magnetic field sensor 422 may also contribute to the gradient coil sensor data 124. In principle gradient coil sensor data from a single sensor may be used for generation of the synthetic gradient coil noise. However, the more sensors and types of sensors that are used to generate the gradient coil sensor data that are used, the better the modeled synthetic gradient coil noise could possibly be.

Adjacent to the imaging zone 408 is a radio-frequency coil 414 for manipulating the orientations of magnetic spins within the imaging zone 408 and for receiving radio transmissions from spins also within the imaging zone 408. The radio frequency antenna may contain multiple coil elements. The radio frequency antenna may also be referred to as a channel or antenna. The radio-frequency coil 414 is connected to a radio frequency transceiver 416. The radio-frequency coil 414 and radio frequency transceiver 416 may be replaced by separate transmit and receive coils and a separate transmitter and receiver. It is understood that the radio-frequency coil 414 and the radio frequency transceiver 416 are representative. The radio-frequency coil 414 is intended to also represent a dedicated transmit antenna and a dedicated receive antenna. Likewise, the transceiver 416 may also represent a separate transmitter and receivers. The radio-frequency coil 414 may also have multiple receive/transmit elements and the radio frequency transceiver 416 may have multiple receive/transmit channels. The transceiver 416 and the gradient amplifier 310 are shown as being connected to the hardware interface 106 of the computer system 101.

The memory 110 is further shown as containing pulse sequence commands 430. This is data or data which may be converted into commands which are used to control the operation and function of the magnetic resonance imaging system 308 such that it is able to acquire k-space data 432. The memory 110 is further shown as containing the k-space data 432 that was acquired by controlling the magnetic resonance imaging system 404 with the pulse sequence commands 430. The memory 110 is further shown as containing a magnetic resonance image 434 that was reconstructed using the k-space data 432.

The memory 110 is shown as optionally containing images of the local user interface 436 that may be transmitted to the remote communication node 320 using the remote access channel 318. In response, the remote computational system 320 of the remote communication node 300 is able to send optional control data 438 via the remote access channel 318. This exchange of the images of the local user interface 436 and the control data 438 enables control of the magnetic resonance imaging system 308 remotely from the remote communication node 300.

The local communication node 102 is also shown as optionally comprising a noise cancellation system 440. In this example the noise cancellation system 440 is placed on the ears of the subject 418 and is used to cancel gradient coil noise within the bore 406 of the magnet 404. In other examples, the noise cancellation system 440 could for example be used to remove noise from a microphone signal from the subject 418 also.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bistable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

| | |
|---|---|
| 100 | communication system |
| 101 | computer |
| 102 | local communication node |
| 104 | local computational system |
| 106 | network / hardware interface |
| 108 | local user interface |
| 110 | local memory |
| 120 | local machine executable instructions |
| 122 | synthetic gradient noise generation module |
| 124 | gradient coil sensor data |
| 126 | synthetic gradient coil noise |
| 200 | receive the gradient coil sensor data from a gradient coil sensor |
| 202 | receive the synthetic gradient coil noise in response to inputting the gradient coil sensor data into the synthetic gradient noise generation module |
| 204 | provide the synthetic gradient coil noise |
| 300 | remote communication node |
| 302 | MR/technical room |
| 304 | control room |
| 306 | remote command center |
| 308 | magnetic resonance imaging system |
| 310 | gradient amplifier |
| 312 | power lines |
| 314 | pick up sensor |
| 316 | short distance transmission channel |
| 318 | remote access channel |
| 320 | remote computational system |
| 322 | decision module |
| 324 | remote audio system |
| 326 | multiple remote access channels |
| 400 | communication system |
| 402 | magnetic resonance imaging system |
| 404 | magnet |
| 406 | bore of magnet |
| 408 | imaging zone |
| 409 | field of view |

410 magnetic field gradient coils
412 magnetic field gradient coil power supply
414 radio-frequency coil
416 transceiver
418 subject
420 subject support
422 magnetic field sensor
430 pulse sequence commands
432 k-space data
434 magnetic resonance image
436 images of local user interface
438 control data
440 noise cancellation system

**Claims**

1. A communication system (100, 400) comprising a local communication node (102), wherein the local communication node comprises:

   - a local memory (110) storing local machine executable instructions (120) and a synthetic gradient noise generation module (122), wherein the synthetic gradient noise generation module is configured to output synthetic gradient coil noise (126) in response to receiving gradient coil sensor data (124) as input;
   - a local computational system (104), wherein execution of the local machine executable instructions causes the local computational system to:

      - receive (200) the gradient coil sensor data from a gradient coil sensor (314, 422);
      - receive (202) the synthetic gradient coil noise in response to inputting the gradient coil sensor data into the synthetic gradient noise generation module; and
      - provide (204) the synthetic gradient coil noise.

2. The communication system of claim 1, wherein the gradient coil sensor data comprises current and/or voltage sensor data from one or more gradient coils.

3. The communication system of any one of claims 1 or 2, wherein the gradient coil sensor data comprises magnetic field sensor data.

4. The communication system of any one of claims 1, 2, or 3, wherein the synthetic gradient noise generation module is implemented as a transfer function.

5. The communication system of any one of claims 1, 2, 3, or 5, wherein the synthetic gradient noise generation module is implemented as a neural network.

6. The communication system of any one of the preceding claims, wherein the communication system further comprises any one of the following: a magnetic resonance imaging system (308), a combined magnetic resonance imaging system (308) and positron emission tomography system, a combined magnetic resonance imaging system (308) and LINAC; wherein the magnetic resonance imaging system further comprises a magnetic gradient coil system, and wherein the communication system further comprises the gradient coil sensor configured for measuring the gradient coil sensor data.

7. The communication system of claim 6, wherein the gradient coil sensor is any one of the following: a current sensor (314) configured for measuring current provided by the gradient coil system, a voltage sensor (314) configured for measuring a voltage drop in the gradient coil system, a magnetic field sensor (422) configured for measuring a gradient magnetic field produced by the magnetic gradient coil system, and combinations thereof.

8. The communication system of any one of claims 1 through 7, wherein the communication system further comprises a network interface (106) configured for establishing a remote access channel (318) between the local communication node and a remote communication node (300); and wherein execution of the local machine executable instructions further causes the local computational system to transmit the synthetic gradient coil noise to the remote communication node via the remote access channel.

9. The communication system of claim 8, wherein the local communication node further comprises:

   - a local user interface (108);
   - a local screen replicator configured for generating images (436) of the local user interface; and
   - a local remote human interface device configured for receiving control data (438) from the remote communication node via the remote access channel, wherein the remote human interface device is further configured to control the local user interface using the control data;

   wherein execution of the local machine executable instructions further causes the local computational system to:

   - transmit the images of the user interface to the remote communication node via the remote access channel;
   - receive the control data from the remote communication node via the remote access channel; and
   - control the user interface using the control data.

**10.** The communication system of claim 9, wherein the communication system further comprises the remote communication node, wherein the remote communication node comprises:

- a remote user interface configured for displaying the images of the user interface received via the remote access channel;
- a remote user interface device configured for receiving the control data and then transmitting the control data via the remote access channel; and
- a remote audio system (324) configured for rendering the synthetic gradient coil noise received via the remote access channel.

**11.** The communication system of claim 9 or 10, wherein the remote communication node is configured for receiving the remote access channel from multiple local communication nodes (326) simultaneously, and wherein the remote communication node is configured to render the synthetic gradient coil noise received via the remote access channel from the local communication node while transmitting control data to a second local communication node.

**12.** The communication system of claim 11, wherein the remote communication node further comprises a decision module (322) configured for choosing the local communication node from the multiple local communication nodes.

**13.** The communication system of any one of the preceding claims, wherein the local communication node further comprises a noise cancellation system (440), wherein execution of the local machine executable instructions further causes the local computational system to control the noise cancellation system with the synthetic gradient coil noise.

**14.** A communication method, wherein the method comprises:

- receiving (200) gradient coil sensor data (124) from a gradient coil sensor (314, 422);
- receiving (202) synthetic gradient coil noise in response to inputting the gradient coil sensor data into a synthetic gradient noise generation module (122), wherein the synthetic gradient noise generation module is configured to output synthetic gradient coil noise in response to receiving gradient coil sensor data as input; and
- providing (204) the synthetic gradient coil noise.

**15.** A computer program comprising local machine executable instructions (120) and a synthetic gradient noise generation module (122), wherein the synthetic gradient noise generation module is configured to output synthetic gradient coil noise (126) in response to receiving gradient coil sensor data (124) as input, wherein execution of the local machine executable instructions causes a local computational system to:

- receive (200) the gradient coil sensor data from a gradient coil sensor (314, 422);
- receive (202) the synthetic gradient coil noise in response to inputting the gradient coil sensor data into the synthetic gradient noise generation module; and
- provide (204) the synthetic gradient coil noise.

Fig. 1

*200*

receive the gradient coil sensor data from a gradient coil sensor

*202*

receive the synthetic gradient coil noise in response to inputting the gradient coil sensor data into the synthetic gradient noise generation module

*204*

provide the synthetic gradient coil noise

Fig. 2

Fig. 3

Fig. 4

EP 4 553 528 A1

Europäisches
Patentamt

European
Patent Office

Office européen
des brevets

# EUROPEAN SEARCH REPORT

**Application Number**

EP 23 20 9384

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2010 041146 A1 (SIEMENS AG [DE]) 22 March 2012 (2012-03-22) | 1-4,6-8, 13-15 | INV. G01R33/385 |
| Y | * the whole document * | 5 | G01R33/54 |
| A | | 9-12 | |
| | ----- | | ADD. |
| X | WO 2022/093023 A1 (UNIV DELFT TECH [NL]) 5 May 2022 (2022-05-05) | 1,4-6, 14,15 | G01R33/48 |
| Y | * page 8, line 24 - line 30; figures 1,4 * | 5 | |
| | ----- | | |
| X | EP 3 771 918 A1 (SIEMENS HEALTHCARE GMBH [DE]) 3 February 2021 (2021-02-03) * paragraph [0084] - paragraph [0092]; figure 1 * | 1,6,14, 15 | |
| | ----- | | |

**TECHNICAL FIELDS SEARCHED (IPC)**

G01R

The present search report has been drawn up for all claims

| Place of search | Date of completion of the search | Examiner |
|---|---|---|
| Munich | 26 April 2024 | Skalla, Jörg |

EPO FORM 1503 03.82 (P04C01)

2

**ANNEX TO THE EUROPEAN SEARCH REPORT
ON EUROPEAN PATENT APPLICATION NO.**

EP 23 20 9384

This annex lists the patent family members relating to the patent documents cited in  the above-mentioned European search report.
The members are as contained in the European Patent Office EDP file on
The European Patent Office is in no way liable for these particulars which are merely given for the purpose of information.

26-04-2024

| Patent document cited in search report | Publication date | Patent family member(s) | | Publication date |
|---|---|---|---|---|
| DE 102010041146 A1 | 22-03-2012 | DE 102010041146 A1 | | 22-03-2012 |
| | | WO    2012038168 A1 | | 29-03-2012 |
| WO 2022093023    A1 | 05-05-2022 | EP       4237866 A1 | | 06-09-2023 |
| | | JP    2023548469 A | | 17-11-2023 |
| | | NL       2026785 B1 | | 21-06-2022 |
| | | US    2024019513 A1 | | 18-01-2024 |
| | | WO    2022093023 A1 | | 05-05-2022 |
| EP 3771918     A1 | 03-02-2021 | NONE | | |

EPO FORM P0459

For more details about this annex : see Official Journal of the European Patent Office, No. 12/82

EP 4 553 528 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200041589 A1